# EUROPEAN PATENT APPLICATION

(11) **EP 1 830 391 A2**
(43) Date of publication of application: **05.09.2007**
(21) Application number: 07103226.2
(22) Date of filing: 28.02.2007
(51) Int. Cl.: H01L 21/00

(54) **Surface protective film peeling method and surface protective film peeling apparatus**

(30) Priority: 02.03.2006 JP 2006056151
(71) Applicant: TOKYO SEIMITSU CO., LTD., Mitaka-shi Tokyo (JP)
(72) Inventor: Ametani, Minoru, Tokyo (JP)
(74) Representative: Skone James, Robert Edmund

(57) **Abstract**

A surface protective film peeling method for peeling off a surface protective film (11) attached on the surface of a wafer (20) is disclosed. The wafer is supported on a movable table (31) with the surface protective film directed up, and an incision (15) is formed at one end (28) of the surface protective film along the surface of the wafer, the peeling tape is attached on the from surface of the portion in which the incision is formed, at one end of the surface protective film, the movable table is moved in the direction toward the one end from the other end (29) of the wafer, and the surface protective film is thus peeled off from the front surface of the wafer. As a result, the surface protective film can be peeled without causing cuts or cracks, etc. in the wafer. Also, in the case where the movable table is moved while holding the portion in which the incision is formed, the surface protective film can be peeled off without using the peeling tape.

## Description

This invention relates to a surface protective film peeling method for peeling the surface protective film attached on the front surface of a wafer and a surface protective film peeling apparatus for carrying out the method.

In the semiconductor manufacturing field, wafers tend to increase in size year by year. Also, wafers have become thinner to improve the mounting density and, in order to reduce the thickness of the wafer, back grinding is carried out to grind the back surface of the semiconductor wafer. During back grinding, a surface protective film is attached on the front surface of the wafer to protect the semiconductor element formed on the front surface of the wafer.

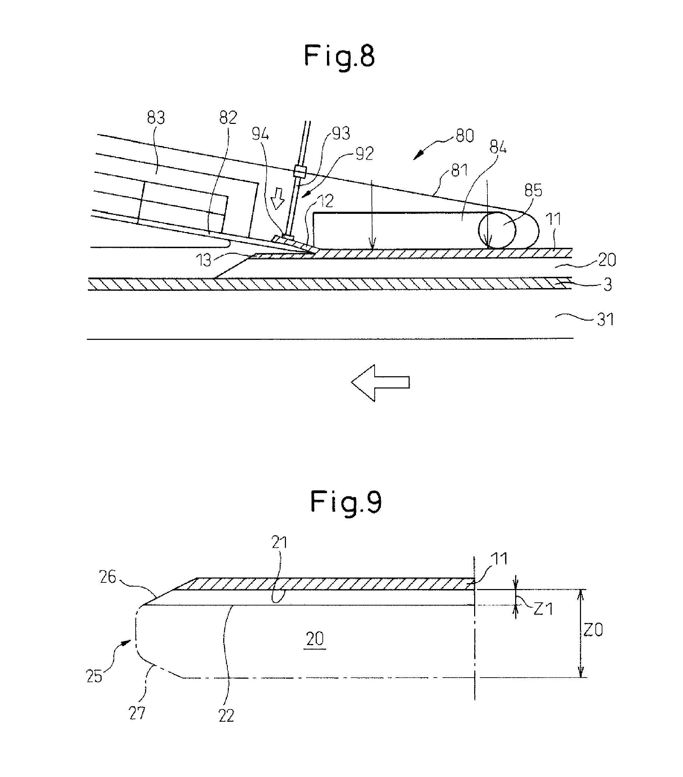

Fig. 9 is an enlarged sectional view of a circular wafer with a surface protective film attached thereon. As can be seen from Fig. 9, an edge portion 25 of the circular wafer 20 is chamfered in advance. Also, the surface protective film 11 for protecting the circuit pattern is attached on the front surface 21 of the wafer 20. As shown in Fig. 9, the edge portion 25 of the wafer 20 is chamfered, and therefore the surface protective film 11 is also cut off diagonally along the chamfered portion of the edge portion 25.

Then, the wafer 20 is back-ground, and when the thickness thereof is reduced from Z0 to Z1, the chamfered portion 27 on the back surface of the wafer 20 is eliminated, and the new back surface 22 (ground surface) of the wafer 20 reaches the chamfered portion 26 on the front surface of the wafer 20. As a result, the edge portion of the wafer 20 is slanted.

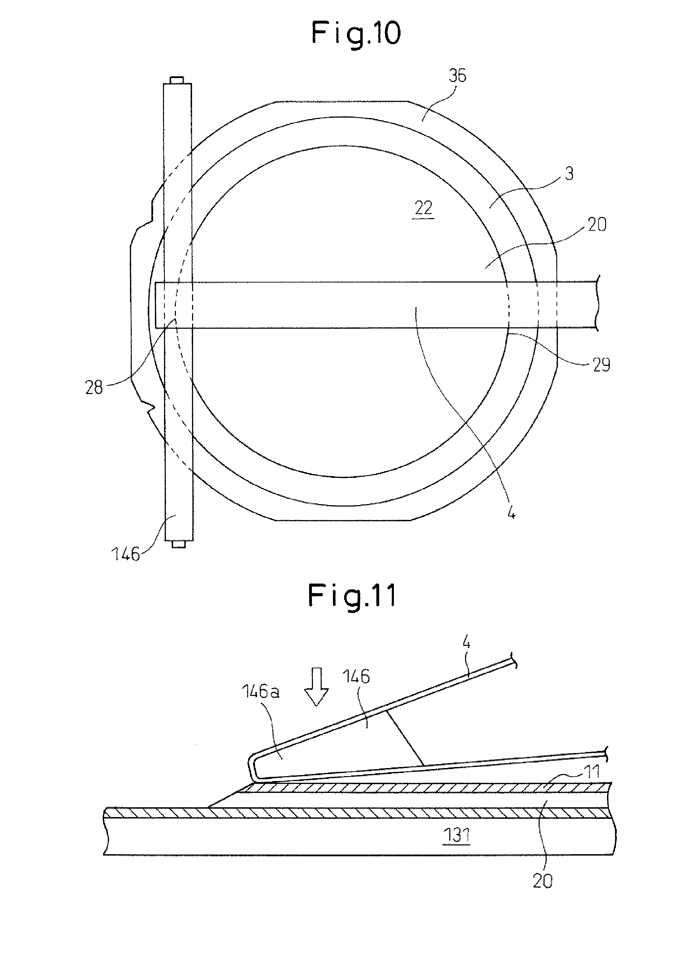

After that, as shown in Fig. 10, a dicing tape 3 is attached on the back surface 22 of the wafer 20, so that the wafer 20 is integrated with a mount frame 36. Then, as shown in Fig. 11, the wafer 20 is supported on a table 131 in such a manner that the surface protective film 11 is located above. A peeling tape 4 is supplied to a peeling member 146 having a substantially triangular section, and the peeling member 146 is pressed against the surface protective film 11 thereby to attach the peeling tape 4 on the surface protective film 11. Next, the table 131 supporting the wafer 20 is moved in horizontal direction. Thus, the place where the peeling tape 4 is attached functions as a peel starting point, and the surface protective film 11 can be peeled off from the wafer 20 continuously starting with the peel starting point (see Japanese Patent Application No. 2005-343744, for example).

As shown in Fig. 11, the forward end of the peeling member 146 is set in position diagonally downward from the horizontal surface and pressed against the surface protective film 11. In view of the fact that the cross sections of the wafer 20 and the surface protective film 11 are substantially in the shape of a trapezoid having the upper bottom smaller than the lower bottom, however, the peeling tape 4 at the forward end 146a of the peeling member 146 may be undesirably bonded to the dicing tape 3 (it should be noted that the thickness of the wafer 20 and the surface protective film 11 is considerably smaller considerably than that of the peeling member 146).

Further, as the thickness of the wafer 20 is greatly reduced, the rigidity of the wafer is also greatly reduced. In the case where the peeling tape 4 is attached on the surface protective film 11 by the peeling member 146, therefore, the wafer 20 may develop cuts or cracks so that the product yield is reduced. Even in the case where no cuts or no cracks occur, the wafer may be internally strained often leading to cuts or cracks in a subsequent step.

A similar problem may arise in the case where the peeling member 146 has no triangular section, or has a circular section, for example.

This invention has been achieved in view of this situation, and the object thereof is to provide a surface protective film peeling method capable of peeling the surface protective film easily and a surface protective film peeling apparatus for carrying out the method.

In order to achieve the object described above, according to a first aspect of the invention, there is provided a surface protective film peeling method for peeling the surface protective film attached on the front surface of the wafer, comprising the steps of supporting the wafer on a movable table with the surface protective film directed up, forming an incision in the thickness of the surface protective film at one thereof of the surface protective film along the front surface of the wafer, attaching the peeling tape on the portion of the surface protective film, in which the incision is formed, at the one end, moving the movable table toward the one end from the other end of the wafer, to peel off the surface protective film from the front surface of the wafer.

According to a second aspect of the invention, there is provided a surface protective film peeling method for peeling the surface protective film attached on the front surface of a wafer, comprising the steps of supporting the wafer on a movable table with the surface protective film directed up, forming an incision in the thickness of the surface protective film at one end of the surface protective film along the front surface of the wafer, holding the portion of the surface protective film in which the incision is formed, and moving the movable table toward the one end from the other end of the wafer thereby to peel the surface protective film from the front surface of the wafer.

According to a third aspect of the invention, there is provided a surface protective film peeling apparatus for peeling off the surface protective film attached on the front surface of a wafer, comprising a movable table for supporting the wafer, with the surface protective film up and adapted to move in horizontal direction, an incision forming means for forming an incision into the thickness of the surface protective film at one end thereof along the front surface of the wafer, and a peeling tape attaching means for attaching the peeling tape on the portion of the surface protective film in which the incision is formed, at the one end of the surface protective film, wherein after attaching the peeling tape, the movable table is moved toward the one end from the other end of the wafer thereby to peel the surface protective film from the front surface of the wafer.

According to a fourth aspect of the invention, there is provided a surface protective film peeling apparatus for peeling off the surface protective film attached on the front surface of a wafer, comprising a movable table for supporting the wafer with the surface protective film up and adapted to move in horizontal direction, an incision forming means for forming an incision into the thickness of the surface protective film at one end thereof along the front surface of the wafer, and a holding means for holding the portion of the surface protective film in which the incision is formed, wherein after holding the portion formed with the notch by the holding means, the movable table is moved toward the one end from the other end of the wafer thereby to peel the surface protective film from the front surface of the wafer.

Specifically, in the first and third aspects, the peeling tape is bonded only at the portion in which the incision is formed, and therefore the peeling tape attaching means is not required to be pressed more than necessary. As a result, while preventing the peeling tape from attaching to the dicing tape, the peeling starting point of the surface protective film can be easily formed to peel off the surface protective film. Also, as the peeling tape attaching means is not required to be pressed more than necessary, the wafer does not develop cuts, cracks or internal strains.

Specifically, in the second and fourth aspects, the movable table is moved simply while holding the incision portion, and therefore the peeling tape and the related peeling tape attaching means can be eliminated. As a result, the peeling tape is not attached on the dicing tape, and the peeling starting point of the surface protective film can be easily formed to peel off the surface protective film. Also, as the peeling tape attaching means can be eliminated, cuts, cracks or internal strains which otherwise might be caused in the wafer by the pressure of the peeling tape attaching means is prevented.

According to a fifth aspect of the invention, there is provided a surface protective film peeling apparatus according to the third or fourth aspect of the invention, wherein the incision forming means can be moved in vertical direction.

Specifically, in the fifth aspect of the invention, the incision forming means can be set in position at an appropriate vertical point between the front surface of the surface protective film and the front surface of the wafer, i.e. at an appropriate position along the thickness of the surface protective film.

According to a sixth aspect of the invention, there is provided a surface protective film peeling apparatus according to any of the third to fifth aspects of the invention, wherein the incision forming means includes a cutting edge portion and a positioning means for determining the position of the forward end of the cutting edge portion.

The cutting edge portion includes a dimensional error due to the regrinding or from one lot to another. According to the sixth aspect, however, the position of the forward end of the cutting edge portion can be fixed by a positioning member after replacing the cutting edge portion.

According to a seventh aspect of the invention, there is provided a surface protective film peeling apparatus according to the sixth aspect, wherein the incision forming means is arranged rotatably around the horizontal axis, and at the time of using the surface protective film peeling apparatus, the cutting edge portion is located under a cover of the incision forming means while at the time of replacing the cutting edge portion, the incision forming means is rotated around the horizontal axis thereby to locate the cutting edge portion above the cover.

Specifically, in the seventh aspect, at the time of replacing the cutting edge portion, the cutting edge portion can be located above the cover at the time of being replaced, and therefore the operator can replace the cutting edge portion visually.

According to an eighth aspect of the invention, there is provided a surface protective film peeling apparatus according to any one of the fourth to seventh aspects of the invention, wherein the holding means is formed integrally with the incision forming means.

Specifically, in the eighth aspect, the space required for the holding means can be reduced in size.

These and other objects, features and advantages of the present invention will be more apparent in light of the detailed description of exemplary embodiments thereof as illustrated by the drawings.

Fig. 1 is a schematic diagram showing a surface protective film peeling apparatus according to this invention.

Fig. 2 is a partly enlarged view of the forward end of the incision forming unit.

Fig. 3 is a detailed diagram showing the incision forming portion.

Fig. 4 is a partly enlarged top plan view of the wafer.

Fig. 5 is a partly enlarged view of a surface protective film peeling apparatus according to this invention.

Fig. 6a is a partly enlarged view showing the incision forming operation of the surface protective film peeling apparatus according to this invention.

Fig. 6b is another partly enlarged view showing the incision forming operation of the surface protective film peeling apparatus according to this invention.

Fig. 7a is a partly enlarged view showing the peeling operation of the surface protective film peeling apparatus according to this invention.

Fig. 7b is a partly enlarged view showing the peeling operation of the surface protective film peeling apparatus according to this invention.

Fig. 7c is a partly enlarged view showing the peeling operation of the surface protective film peeling apparatus according to this invention.

Fig. 8 is a partly enlarged view showing the surface protective film peeling apparatus according to another embodiment of this invention.

Fig. 9 is an enlarged sectional view of the wafer with the surface protective film attached thereon.

Fig. 10 is a top plan view of a wafer integrated with a mount frame.

Fig. 11 is a sectional view showing the state in which the peeling tape is attached on the surface protective film of the wafer according to the prior art.

Embodiments of the invention are explained below with reference to the accompanying drawings. In the drawings, the similar component members are designated by the similar reference numerals, respectively. To facilitate understanding, the scale of the drawings is changed appropriately.

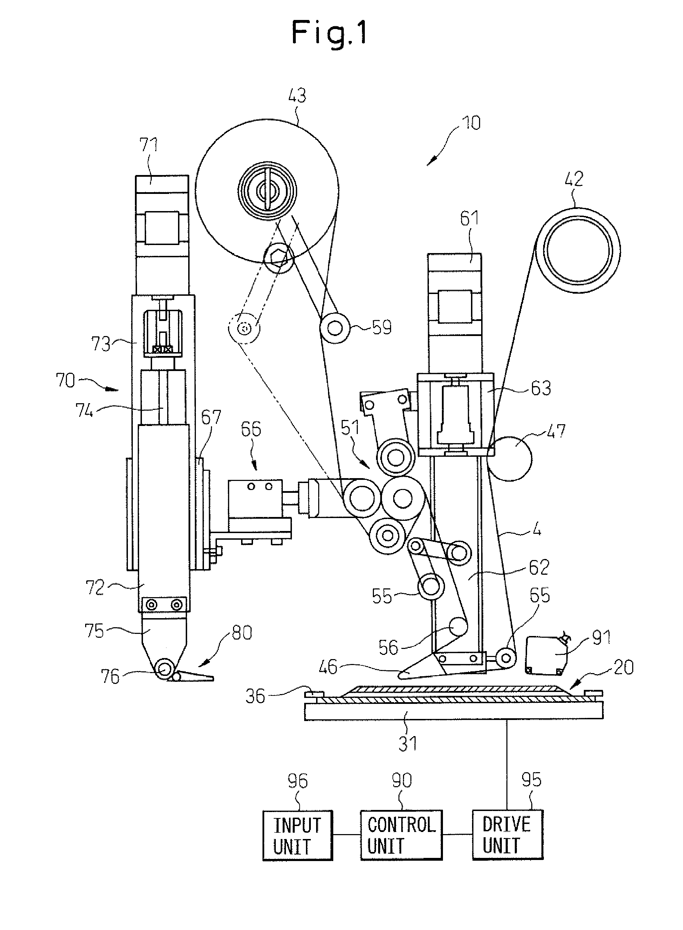

Fig. 1 is a schematic diagram showing a surface protective film peeling apparatus according to this invention. A wafer 20 is supplied to a surface protective film peeling apparatus 10, as explained with reference to Fig. 9. The back surface thereof is ground to a chamfered portion 26 by back grinding, and the thickness of the wafer 20 is not more than 100 micrometer. Also, as is well known, a surface protective film 11 for protecting the circuit pattern is already attached on the front surface of the wafer 20. Further, a dicing tape 3 is attached on the ground surface 22 of the wafer 20, which in turn is integrated with a mount frame 36 by the dicing tape 3.

The surface protective film peeling apparatus 10 shown in Fig. 1 includes a supply unit 42 for supplying the peeling tape 4 to be attached on the surface protective film 11 of the wafer 20, and a take-up unit 43 for taking up the peeling tape from the supply unit 42. Also, a control unit 90 such as a digital computer is arranged under the surface protective film peeling apparatus 10. The peeling tape 4 used in the description below is what is called a pressure-sensitive tape exhibiting the sticking function under pressure or a heat-sensitive exhibiting the sticking function by heat.

As shown in Fig. 1, guide rolls 47, 65 for guiding the peeling tape 4 while applying a predetermined tension to the peeling tape 4 are arranged downstream of the supply unit 42. The peeling tape 4 is led to the take-up unit 43 through a peeling member 46 of the surface protective film peeling apparatus 10. As shown, the peeling member 46 has a rectangular or triangular cross section and is arranged in such a direction as to contact the wafer 20 with a small area. Further, a guide roll 56, a dancer roll 55, a pair of guide rolls 51 and another dancer roll 59 are arranged between the peeling member 46 and the take-up unit 43. The dancer rolls 55, 59 are operated in accordance with the supplied amount of the peeling tape 4.

The surface protective film peeling apparatus 10 includes a shaft 62 inserted in the cover guide unit 63. Also, a motor 61 is mounted above the cover guide unit 63. As shown, the peeling member 46 is arranged at the bottom end portion of the shaft 62, and the guide rolls 56, 65 associated with the peeling member 46 are arranged at predetermined points on the shaft 62. When the shaft 62 is moved vertically by the motor 61 along the cover guide unit 63, therefore, the peeling member 46 and the guide rolls 56, 65 are also integrally moved vertically. The shaft 62 may be moved vertically using an air cylinder.

A sensor 91 is arranged behind the guide roll 65. The sensor 91 can detect the position of the edge portion of the wafer 20 supported on the movable table 31 described later. This sensor 91 is also connected to the control unit 90.

Further, as can be seen by referring again to Fig. 1, the input unit 96 such as the keyboard or the mouse is connected to the control unit 90. The operator can appropriately input the thickness of the wafer 20 after back grinding and/or the thickness of the surface protective film 11 and the thickness of the dicing tape 3 from the input unit 96.

In Fig. 1, the incision forming unit 70 is arranged on the left side of the shaft 62. As shown, a holder 67 arranged on a coupling unit 66 extending from the cover guide unit 63 holds the cover guide unit 73 of the incision forming unit 70. The incision forming unit 70 includes a slider 72 arranged in front of the cover guide unit 73 and a motor 71 mounted above the cover guide unit 73.

A bracket 75 having a incision forming portion 80 described later is screwed to the bottom end portion of the slider 72. When the slider 72 is moved vertically along a guide rail 74 of the cover guide unit 73 by the motor 71, the bracket 75 and the incision forming portion 80 are also moved integrally in vertical direction. The shaft 72 may of course be moved vertically using the air cylinder.

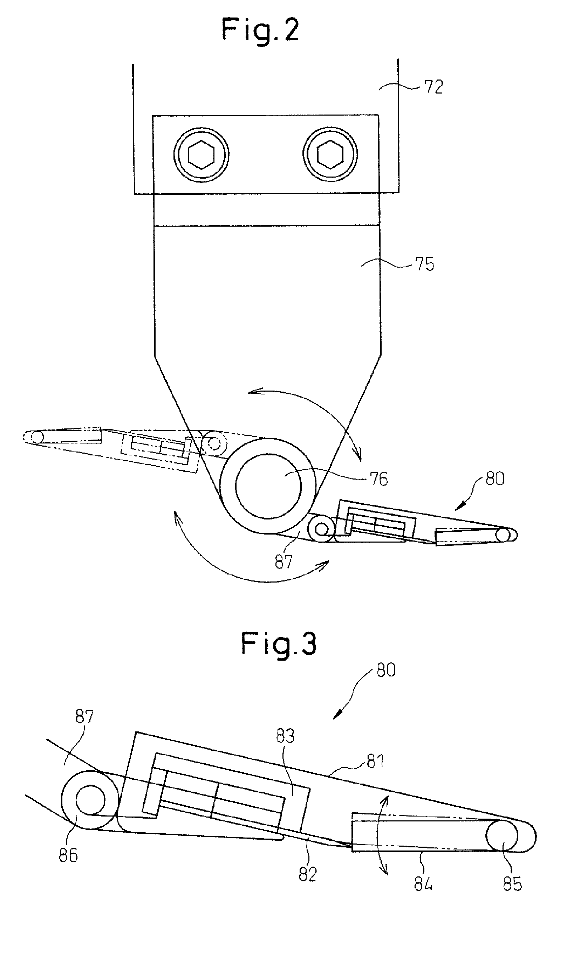

Fig. 2 is a partly enlarged view of the forward end of the incision forming unit. A horizontal axis unit 76 is arranged in a position perpendicular to the length of the peeling tape 4 at the forward end of the bracket 75. The incision forming portion 80 is coupled to the horizontal axis unit 76 by a coupling arm 87. As indicated by arrows in Fig. 2, therefore, the incision forming portion 80 can rotate around the horizontal axis unit 76.

Fig. 3 is a diagram showing the incision forming portion 80 in detail. A cutting edge portion 82 is fixed on the lower surface of the cover 81 of the incision forming portion 80 by a fixing member 83, and a positioning member 84 is arranged to force the forward end of the cutting edge portion 82. Specifically, the cover 81 functions as a safety cover for preventing the operator from touching the cutting edge portion 82.

The positioning member 84 is formed in such a manner as to rotate around a shaft 85 on the lower surface of the cover 81. Further, the positioning member 84 is kept urged away from the cover 81 by a spring (not shown) arranged on the shaft 85. When the positioning member 84 is located at its initial position as indicated by the solid line in Fig. 3, therefore, the forward end of the positioning member 84 is located slightly lower than the shaft 85.

The positioning member 84 is used to determine the forward end position of the cutting edge portion 82. Specifically, when the positioning member 84 is located at the initial position, the forward end of the cutting edge portion 82 is adjusted to come into contact with the forward end of the positioning member 84. After adjustment of the forward end position of the cutting edge portion 82, the cutting edge portion 82 is fixed by the fixing member 83.

Normally, the size of the forward end of the cutting edge portion 82 is varied in accordance with the protracted use, by lot or by regrinding the cutting edge portion 82. According to this invention, therefore, the forward end position of the cutting edge portion 82 can be maintained constant by bringing the forward end of the cutting edge portion 82 into contact with the forward end of the positioning member 84. The incision forming portion 80 is also rotatable around the shaft 86 of the coupling arm 87, whereby the position of the incision forming portion 80 can be finely adjusted. As shown in Fig. 3, the cross section of the forward end of the cutting edge portion 82 is substantially in the shape of an isosceles triangle, and in the normal state of the incision forming portion 80, the lower side of the forward end of the cutting edge portion 82 is substantially horizontal.

As can be seen by referring to Fig. 2 again, the incision forming portion 80 is rotated by about 180 degrees around the horizontal shaft 76 (refer to Fig. 2) when newly mounting or replacing the cutting edge portion 82 of the incision forming portion 80. As a result, the cover 81 of the incision forming portion 80 comes to be located under the cutting edge portion 82. Specifically, the fixing member 83 comes to be exposed, and therefore the operator can visually mount or replace the cutting edge portion 82. After that, the forward end position of the cutting edge portion 82 can be adjusted visually and easily.

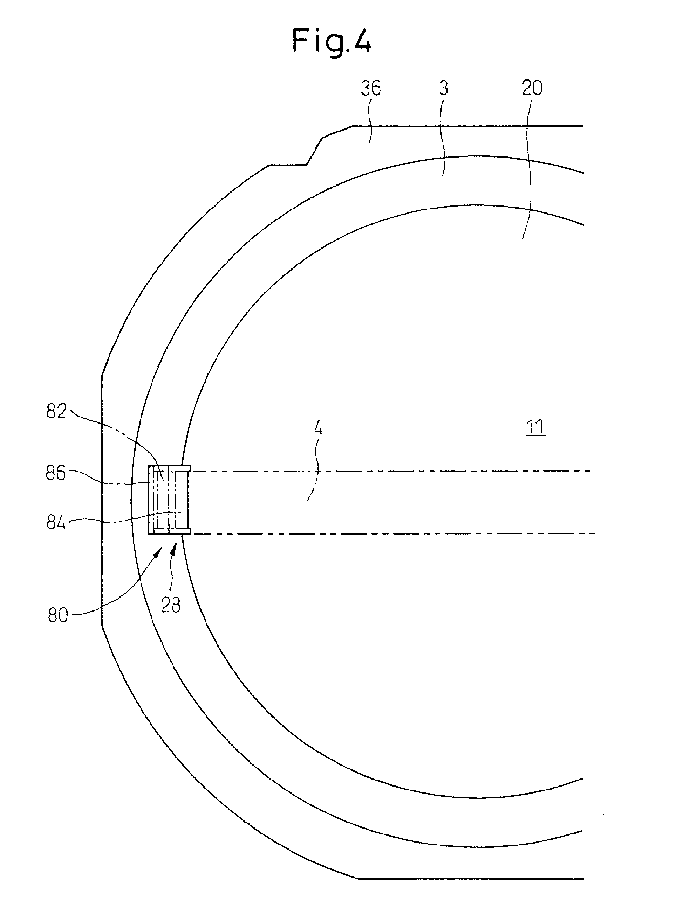

Fig. 4 is a partly enlarged top plan view of the wafer. As shown in Fig. 4, the width of the cutting edge portion 82 of the incision forming portion 80 is sufficiently small as compared with the size of the wafer 20 on the one hand and substantially equal to the width of the peeling tape 4 on the other hand. As a result, the incision forming operation described later is performed only at the required minimum points, thus the load imposed on the wafer 20 at the time of forming the incision can be reduced. As will be understood, this is advantageous for peeling the surface protective film 11 of the wafer 20, the thickness thereof is reduced by back grinding.

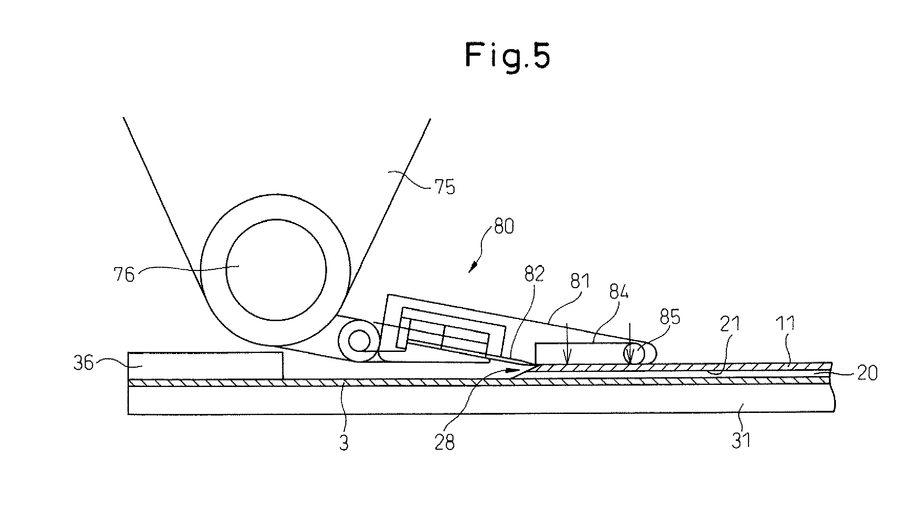

Fig. 5 is a partly enlarged view of the surface protective film peeling apparatus according to the invention. A movable table 31 is arranged under the surface protective film peeling apparatus 10. The movable table is connected to a drive unit 95 (refer to Fig. 1) and adapted to move in horizontal direction. The wafer 20 is supported on the movable table 31 while the front surface 21 with the surface protective film 11 attached thereon is directed up. When the wafer 20 is supported, therefore, the dicing tape 3 attached on the back surface 22 of the wafer 20 is in direct contact with the movable table 31.

The mount frame 36 integrated with the wafer 20 by the dicing tape 3 functions to hold each portion of the wafer 20 when cut into dies at the time of dicing. The wafer 20 is assumed to be supported by a well known means such as vacuum adsorption on the movable table 31.

The peeling operation of the surface protective film peeling apparatus 10 according to this invention is explained. First, the movable table 31 is moved to the position under the incision forming portion 80 of the incision forming unit 70. Specifically, the movable table 31 is moved so that the incision forming portion 80 at a predetermined height comes to be located between the mount frame 36 and the wafer 20. The distance covered by the movable table 31 is calculated by the control unit 90 based on the predetermined distance between the peeling member 46 and the incision forming unit 70 and the position of the wafer 20 such as the position of the edge portion of the wafer 20 detected by the sensor 91.

After that, the shaft 72 of the incision forming unit 70 is slid downward along the guide rail 74. The distance by which the shaft 72 is slid downward is determined in accordance with the thickness of the back-ground wafer 20, the dicing tape 3 and the surface protective film 11. These thickness are desirably input in advance from the input unit 96. In this case, the incision forming portion 80 can be accurately moved downward. By sliding the shaft 72, the positioning member 84 of the incision forming portion 80 is brought into contact with the surface protective film 11 of the wafer 20 as shown in Fig. 5, and slightly rotated upward against the urging force of the positioning member 84. In other words, the wafer 20 is pressed by the positioning member 84.

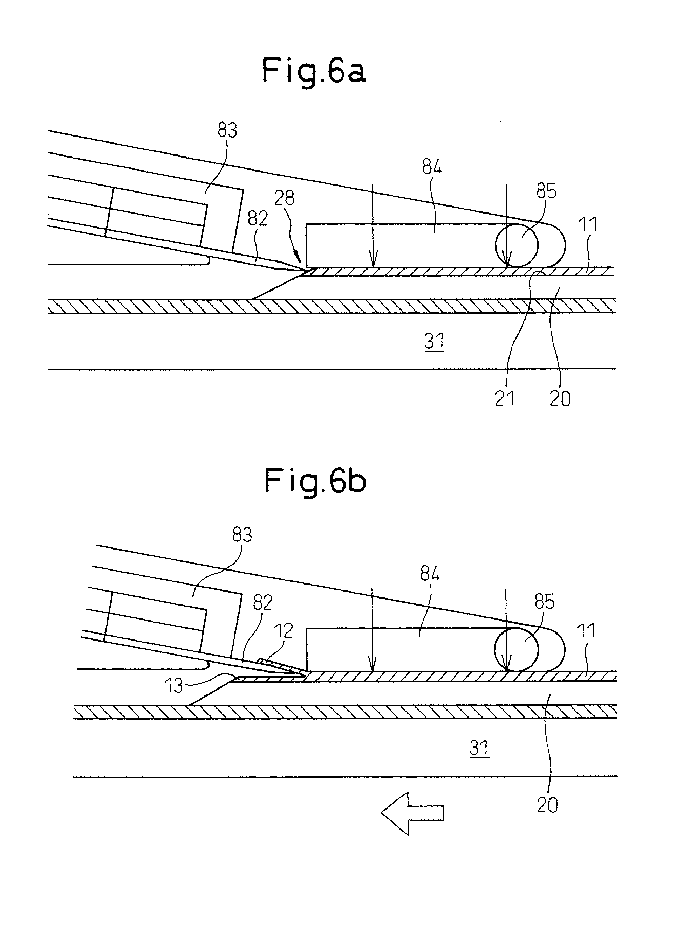

The upward rotation of the positioning member 84, on the other hand, exposes the forward end of the cutting edge portion 82 from the positioning member 84. As shown in the partly enlarged view of Fig. 6a illustrating the operation of the surface protective film peeling apparatus 10, the exposed forward end of the cutting edge portion 82 comes to be located to face the edge portion 28 of the surface protective film 11 attached on the front surface of the wafer 20. More preferably, the forward end of the cutting edge portion 82 is arranged between the boundary between the surface protective film 11 and the front surface 21 of the wafer 20 on the one hand and the point half along the thickness of the surface protective film 11 on the other hand. As an alternative, the forward end of the cutting edge portion 82 may be arranged at a position corresponding to the sticking layer (not shown) of the surface protective film 11.

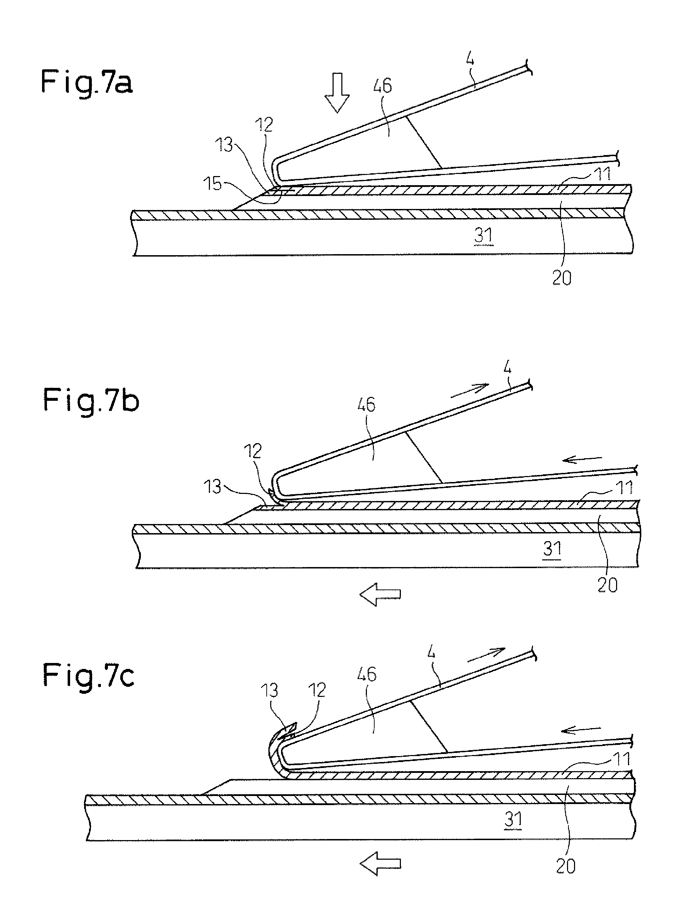

Next, as shown in Fig. 6b, the movable table 31 is moved by a predetermined minuscule distance further toward the incision forming unit 70. This minuscule distance is 1 mm, for example, i.e. a so short a distance that the forward end of the cutting edge portion 82 does not reach the circuit pattern (not shown) formed on the front surface 21 of the wafer 20. With the movement of the movable table 31 by a minuscule distance, the forward end of the cutting edge portion 82 advances into the thickness of the surface protective film 11, so that the surface protective film 11 is partially cut along the front surface thereof. As a result, the edge portion 28 of the surface protective film 11 is divided into a lower piece 13 left attached on the wafer 20 and an upper piece 12 riding over the cutting edge portion 82. After that, the movable table 31 is moved in the opposite direction and the cutting edge portion 82 is retreated. Then, the upper piece 12 is returned substantially to the original position by the elasticity thereof, and a incision 15 is formed between the upper piece 12 and the lower piece 13 (see Fig. 7).

After the incision 15 is formed, the shaft 72 of the incision forming unit 70 is moved up, while the movable table 31 is returned to a position under the peeling member 46. As a result, the edge portion 28 of the surface protective film 11 corresponding to the upper piece 12 comes to be located under the forward end of the peeling member 46.

Figs. 7a to 7c are partly enlarged views showing the peeling operation of the surface protective film peeling apparatus 10 according to the invention. By driving the motor 61, the shaft 62 of the the surface protective film peeling apparatus 10 is moved down until the forward end of the peeling member 46 reaches the edge portion 28 of the surface protective film 11, as shown in Fig 7a. The distance by which the shaft 62 moves downward is determined based on the thickness of the wafer 20, the dicing tape 3, the surface protective film 11 and the peeling tape 4 input in advance from the input unit 96. Even in the case where the degree of back grinding of the wafer 20 and/or the thickness of the surface protective film 11 varies from one wafer 20 or lot to another, therefore, the peeling member 46 of the shaft 62 can be accurately moved down.

As can be seen from Fig. 7a, the peeling member 46 is moved down in such a manner as to press the surface of the upper piece 12 the surface protective film 11, namely a portion in which the incision 15 is formed. As a result, the peeling tape 4 wound on the peeling member 46 is attached on the upper piece 12. According to this invention, the peeling tape 4 is pressed against the peeling member 46 in such a manner as to adhere only the upper piece 12, and therefore, the required pressure force of the peeling member 46 may be comparatively small. Thus, no cuts, cracks or internal strains are caused in the wafer 20. Further, the peeling member 46 is required to come into contact only with the upper piece 12, and therefore, the peeling tape 4 is prevented from being attached on the dicing tape 3.

Next, as shown in Fig. 7b, the movable table 31 is moved slightly toward the incision forming unit 70, i.e. along the diameter toward the edge portion 28 from the other edge portion 29 of the wafer 20 (Fig. 10). This distance may be about equal to, for example, the minuscule distance described above. Thus, the peeling tape 4 of the peeling member 46 is moved in relation to the motion of the movable table 31, so that the upper piece 12 of the surface protective film 11 is pulled in accordance with the movement of the peeling tape 4. Since the upper piece 12 is pulled, the lower piece 13 is also pulled from the root, i.e. the deepest portion of the incision 15 and peeled off from the wafer 20.

Upon further movement of the movable table 31 toward the incision forming unit 70 as shown in Fig. 7c, the lower piece 13 is completely peeled off from the wafer 20. Still further movement of the movable table 31 successively peels off the surface protective film 11 adjacent to the lower piece 13. In the case where the movable table 31 is moved until the edge portion 29 on the other side of the wafer 20 passes through the peeling member 46, the surface protective film 11 can be completely peeled off from the wafer 20. In this way, according to this invention, a part of the surface protective film 11 in which the incision 15 is formed, functions as a peeling starting point, and therefore, the surface protective film 11 can be easily peeled off.

Fig. 8 is a partly enlarged view of the surface protective film peeling apparatus according to another embodiment of the invention. In Fig. 8, the incision forming portion 80 includes a holding member 92. The holding member 92 includes a rod 93 extending toward the side surface of the cutting edge portion 82 through the cover 81 and a press unit 94 mounted at the forward end of the rod 93. The rod 93 is formed in such as manner as to extend and contract in the direction perpendicular to the cover 81 by a well-known method. Incidentally, the drive source, etc. of the rod 93 are not shown.

According to the embodiment shown in Fig. 8, after the surface protective film 11 is cut in by the cutting edge portion 82 as described above, the rod 93 is extended toward the cutting edge portion 82. The press unit 94 of the rod 93 is pressed against the cutting edge portion 82, so that the upper piece 12 of the surface protective film 11 is held between the press unit 94 and the cutting edge portion 82.

Next, the upper piece 12 is held by the holding member 92, after which the incision forming portion 80 is slightly moved upward by an approximate amount equal to, for example, the thickness of the surface protective film 11, followed by moving the movable table 31 toward the edge portion 28 from the edge portion 29. Once the upper piece 12 is pulled by the holding member 92, the lower piece 13 is also pulled from the root of the incision 15 and peeled off from the wafer 20. In a similar fashion, the surface protective film 11 can be peeled off completely from the wafer 20. As a result, the surface protective film 11 can be smoothly peeled off.

Further, according to the embodiment shown in Fig. 8, the use of the peeling member 46 and the peeling tape 4 can be eliminated. As a result, the wafer 20 is prevented from developing cuts, crackings or internal strains by the pressure of the peel member 46.

In the embodiment explained above with reference to Fig. 8, the holding member 92 is arranged on the cover 81 of the incision forming portion 80. Nevertheless, the holding member 92 may be a member independent of the incision forming portion 80 as a configuration in which the holding member 92 can hold the upper piece 12 by itself. In such a case, the incision forming portion 80 is retreated, after which the surface protective film 11 is peeled off using the holding member 92. Although the foregoing explanation concerns a case in which the dicing tape 36 is attached on the back surface 22 of the wafer 20, the case in which the surface protective film 11 of the wafer 20 with the dicing tape 36 not attached thereon is also included in the scope of the invention.

## Claims

1. A surface protective film peeling method for peeling the surface protective film attached on the front surface of a wafer, comprising the steps of:
supporting the wafer on a movable table with the surface protective film directed up;
forming an incision into the thickness of the surface protective film at one end of the surface protective film along the surface of the wafer;
attaching the peeling tape on the portion of the surface protective film, in which the incision is formed, at the one end; and
moving the movable table in the direction toward the one end from the other end of the wafer to peel off the surface protective film from the front surface of the wafer.

2. A surface protective film peeling method for peeling the surface protective film attached on the front surface of a wafer, comprising the steps of:
supporting the wafer on a movable table with the surface protective film directed up;
forming an incision into the thickness of the surface protective film at one end of the surface protective film along the surface of the wafer;
holding the portion of the surface protective film in which the incision is formed; and
moving the movable table in the direction toward the one end from the other end of the wafer to peel off the surface protective film from the front surface of the wafer.

3. A surface protective film peeling apparatus for peeling the surface protective film attached on the front surface of a wafer, comprising:
a movable table for supporting the wafer with the surface protective film directed up and adapted to move in the horizontal direction;
an incision forming means for forming an incision into the thickness of the surface protective film at one end of the surface protective film along the front surface of the wafer; and
a peeling tape attaching means for attaching the peeling tape on the portion of the surface protective film, in which the incision is formed, at the one end of the surface protective film;
wherein the surface protective film is peeled off from the front surface of the wafer by moving the movable table in the direction toward the one end, from the other end of the wafer, after attaching the peeling tape.

4. A surface protective film peeling apparatus for peeling the surface protective film attached on the front surface of a wafer, comprising:
a movable table for supporting the wafer with the surface protective film directed up and adapted to move in the horizontal direction;
an incision forming means for forming an incision into the thickness of the surface protective film at one end of the surface protective film along the front surface of the wafer; and
a holding means for holding the portion of the surface protective film in which the incision is formed;
wherein the surface protective film is peeled off from the front surface of the wafer by moving the movable table in the direction toward the one end, from the other end of the wafer, after holding the portion in which the incision is formed, by the holding means.

5. A surface protective film peeling apparatus according to claim 3 or 4, wherein the incision forming means can be moved in vertical direction.

6. A surface protective film peeling apparatus according to any of claims 3 to 5, wherein the incision forming means includes a cutting edge portion and a positioning means for setting the forward end of the cutting edge portion in position.

7. A surface protective film peeling apparatus according to claim 6,
wherein the incision forming means is arranged rotatably around the horizontal axis,
wherein the cutting edge portion is located under a cover of the incision forming means at the time of using the surface protective film peeling apparatus, and
at the time of replacing the cutting edge portion, the incision forming means is rotated around the horizontal axis and the cutting edge portion thereby comes to be located above the cover.

8. A surface protective film peeling apparatus according to any one of claims 4 to 7, wherein the holding means is formed integrally with the incision forming means.
